# EUROPEAN PATENT APPLICATION

(11) **EP 4 733 784 A1**
(43) Date of publication of application: **29.04.2026**
(21) Application number: 24831391.8
(22) Date of filing: 25.04.2024
(51) Int. Cl.: G01R 31/389, H01M 10/48

(54) **STORAGE BATTERY INSPECTION DEVICE AND STORAGE BATTERY INSPECTION METHOD**

(30) Priority: 26.06.2023 JP 2023103925
(71) Applicant: Integral Geometry Science Inc., Kobe-shi, Hyogo, 657-8501 (JP)
(72) Inventor: MATSUDA, Seiju, Kobe-shi, Hyogo 657-8501 (JP); SUZUKI, Shogo, Kobe-shi, Hyogo 657-8501 (JP); KIMURA, Noriaki, Kobe-shi, Hyogo 657-8501 (JP); KIMURA, Kenjiro, Kobe-shi, Hyogo 657-8501 (JP)
(74) Representative: KATZAROV S.A.
(86) International application number: PCT/JP2024/016311
(87) International publication number: WO 2025/004516

(57) **Abstract**

Storage battery inspection device (10) includes a charge control circuit (11) that applies an AC current to a storage battery (31), a magnetic sensor (12) that senses a magnetic field external to the storage battery (31), a calculation unit (76) that calculates an AC current flowing through the storage battery (31) based on a sensing result from the magnetic sensor (12), and a correction unit (77) that calculates, based on a calculation result from the calculation unit (76), one or more vectors (I_{abnormal}, Iₙₒᵣₘₐₗ) on a complex plane representing the AC current flowing through the storage battery (31), calculates one or more projection vectors (I'_{abnormal}, I'ₙₒᵣₘₐₗ) by projecting the calculated one or more vectors (I_{abnormal}, Iₙₒᵣₘₐₗ) onto a predetermined straight line on the complex plane, and outputs a corrected signal indicating magnitudes of the calculated one or more projection vectors (I'_{abnormal}, I'normal).

## Description

### [Technical Field]

The present disclosure relates to a storage battery inspection device and the like for inspecting storage batteries.

### [Background Art]

Patent Literature (PTL) 1 discloses a technique related to an evaluation device for inspecting secondary batteries. In the technique described in PTL 1, a controller calculates magnitudes of currents flowing through different portions of a secondary battery from a magnetic field detected by a magnetic sensor, and extracts magnitudes of currents in an electrolyte region located between electrodes. The controller then generates a graph illustrating the distribution pattern of the magnitudes of the currents, and displays this graph on a display device. Note that secondary batteries are also referred to as storage batteries.

### [Citation List]

### [Patent Literature]

[PTL 1] Japanese Unexamined Patent Application Publication No. 2013-32985

### [Summary of Invention]

### [Technical Problem]

When detecting early-stage anomalies inside a storage battery using an external magnetic sensor, the spatial separation between the magnetic sensor and the potential anomalous portion means that the magnetic sensor's detection surface receives magnetic field lines generated by currents flowing through various different parts of the storage battery, making it difficult to precisely identify and visualize the location of the anomaly within the storage battery.

Therefore, in addition to the difficulty of identifying anomalous portions based on current magnitudes calculated by non-analytical methods from magnetic fields external to the storage battery, even when visualizing using analytical methods, it is essential to appropriately process the data used as boundary conditions before calculation. For example, the evaluation device of PTL 1 is not based on analytical inverse problem solving methods and cannot appropriately inspect storage batteries.

In view of this, the present disclosure provides a storage battery inspection device and the like that can more appropriately inspect storage batteries.

### [Solution to Problem]

A storage battery inspection device according to one aspect of the present disclosure includes: an application unit configured to apply an alternating current (AC) current to a storage battery; a sensing unit configured to sense a magnetic field external to the storage battery; a calculation unit configured to calculate an AC current flowing through the storage battery based on a sensing result from the sensing unit; and a correction unit configured to calculate, based on a calculation result from the calculation unit, one or more vectors on a complex plane representing the AC current flowing through the storage battery, calculate one or more projection vectors by projecting the one or more vectors calculated onto a predetermined straight line on the complex plane, and output a corrected signal indicating magnitudes of the one or more projection vectors calculated.

General or specific aspects of the present disclosure may be realized as a system, a device, a method, an integrated circuit, a computer program, or a computer-readable non-transitory recording medium such as a CD-ROM, or any given combination thereof.

### [Advantageous Effects of Invention]

According to one aspect of the present disclosure, storage batteries can be more appropriately inspected.

### [Brief Description of Drawings]

[FIG. 1]

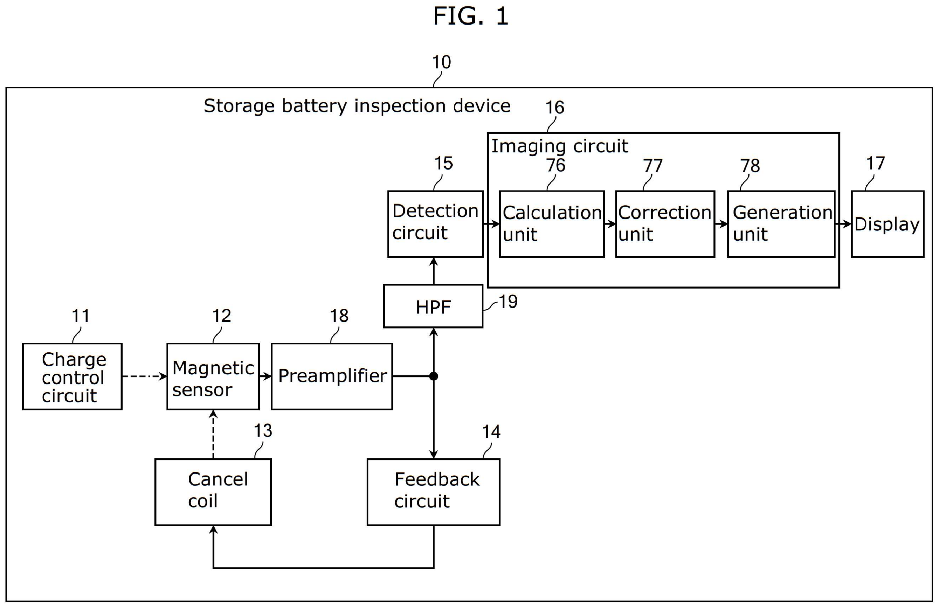

   FIG. 1 is a block diagram illustrating the configuration of a storage battery inspection device according to an embodiment of the present disclosure.
[FIG. 2]

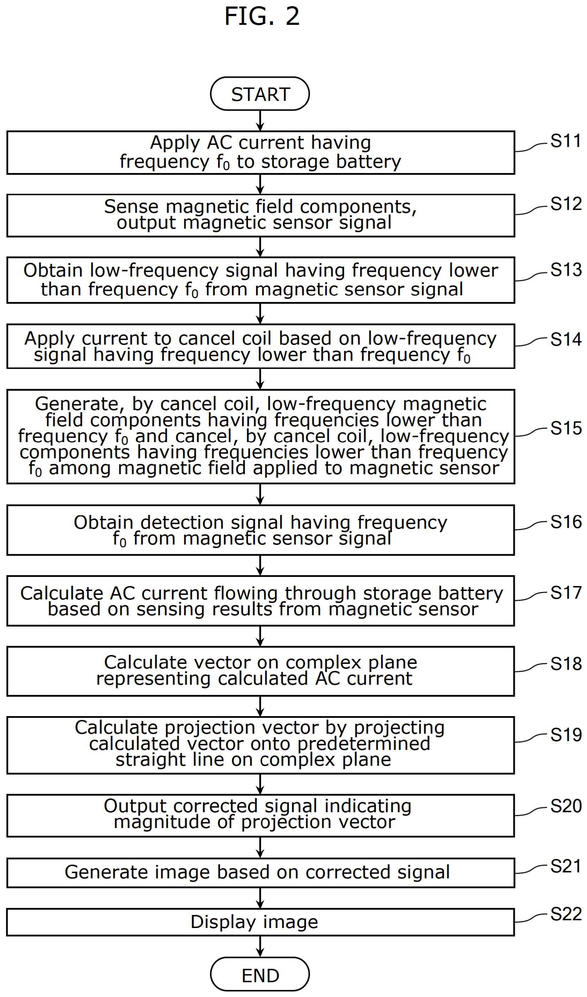

   FIG. 2 is a flowchart illustrating the operation of a storage battery inspection device according to an embodiment of the present disclosure.
[FIG. 3]

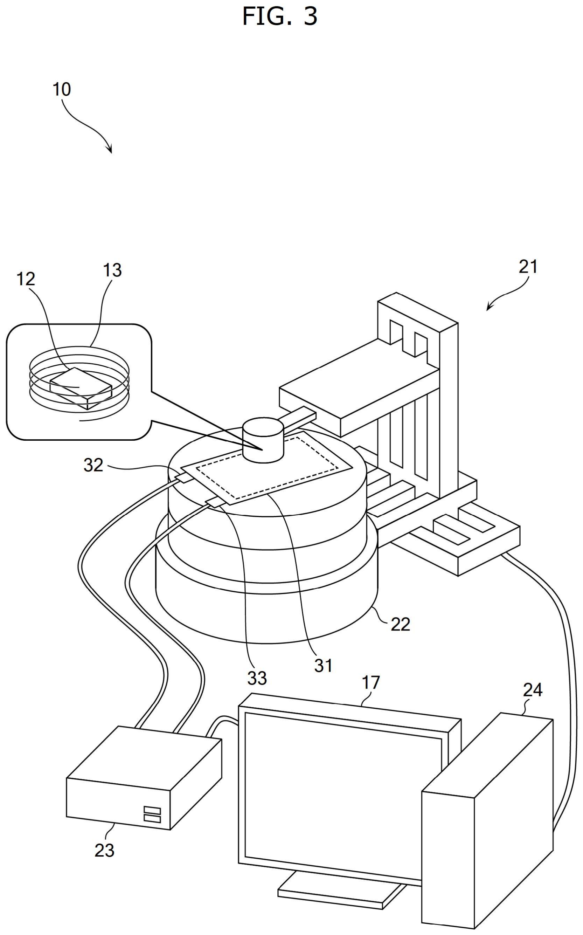

   FIG. 3 is a conceptual diagram illustrating a specific configuration of a storage battery inspection device according to an embodiment of the present disclosure.
[FIG. 4]

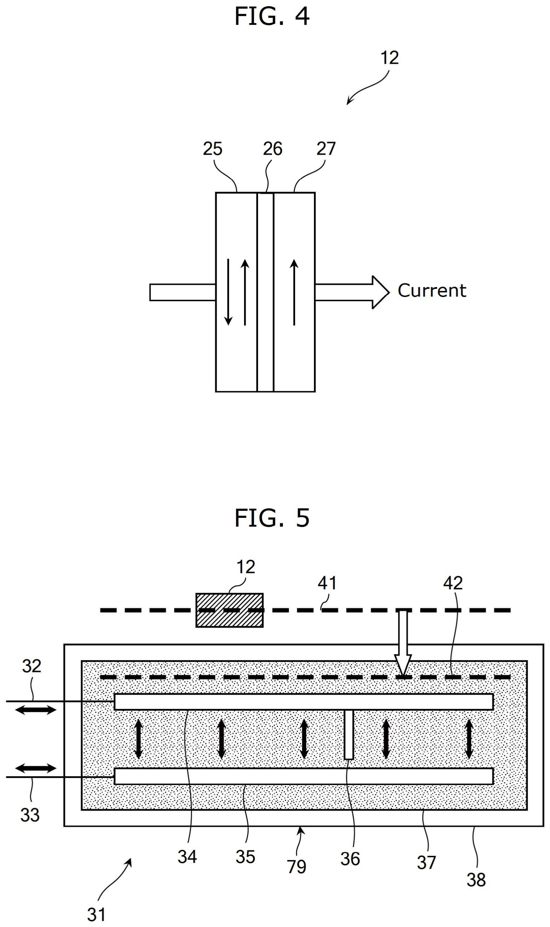

   FIG. 4 is a conceptual diagram illustrating a specific structure of a magnetic sensor according to an embodiment of the present disclosure.
[FIG. 5]
   FIG. 5 is a conceptual diagram illustrating a state in which a storage battery according to an embodiment of the present disclosure is being inspected.
[FIG. 6]

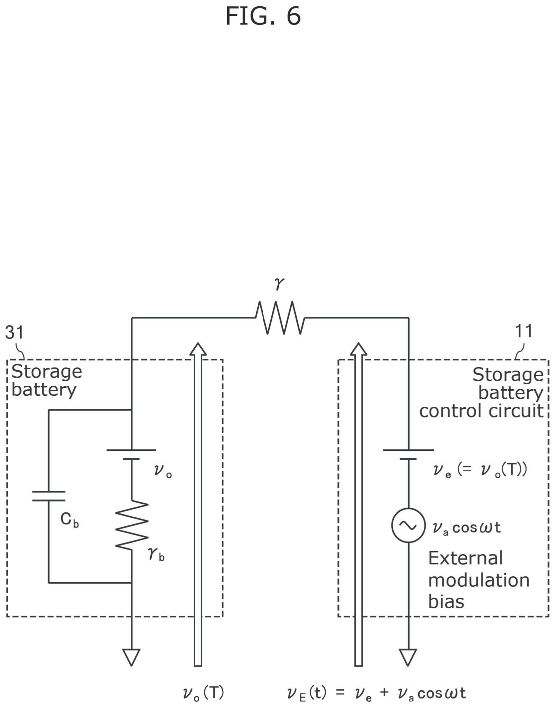

   FIG. 6 is a conceptual diagram illustrating a circuit for applying AC voltage according to an embodiment of the present disclosure.
[FIG. 7]

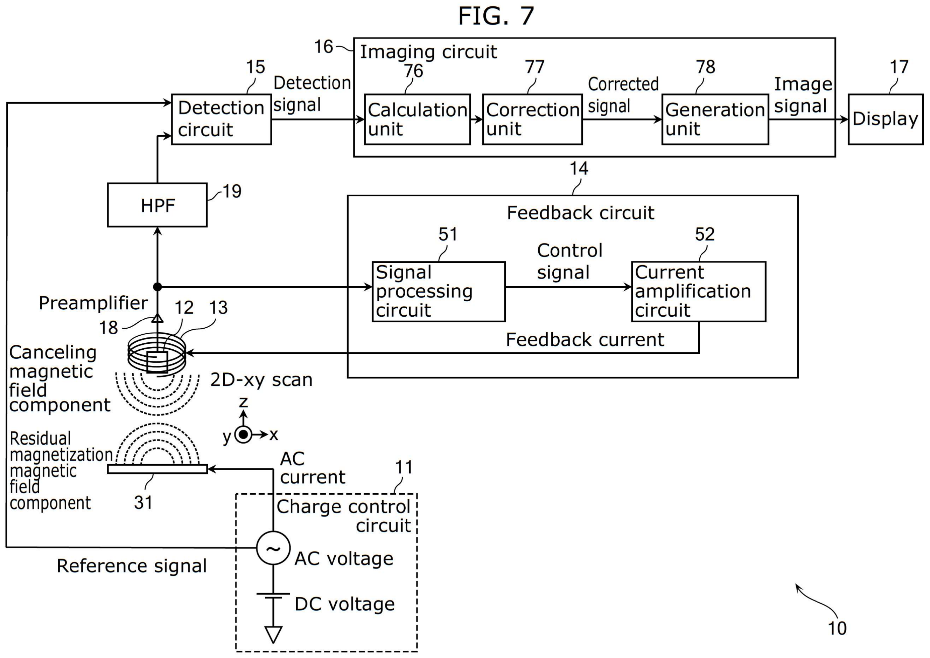

   FIG. 7 is a conceptual diagram illustrating the overall configuration of a storage battery inspection device according to an embodiment of the present disclosure.
[FIG. 8]

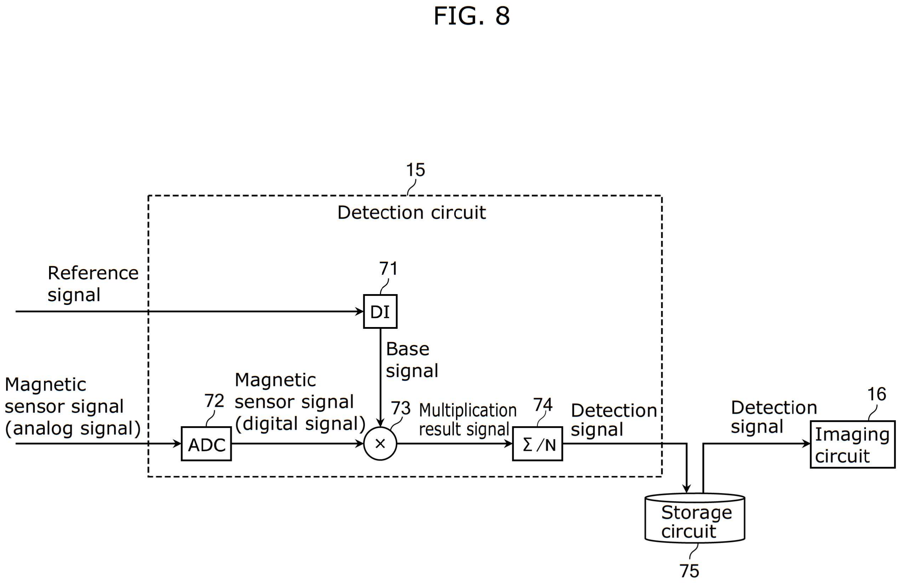

   FIG. 8 is a block diagram illustrating the configuration of a detection circuit according to an embodiment of the present disclosure.
[FIG. 9]

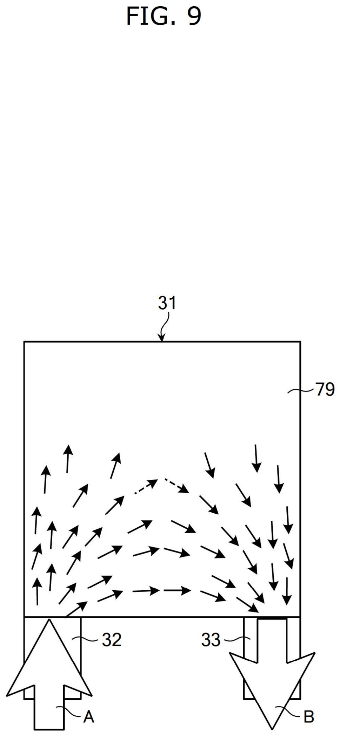

   FIG. 9 is a conceptual diagram illustrating AC current flowing through a storage battery according to an embodiment of the present disclosure.
[FIG. 10]

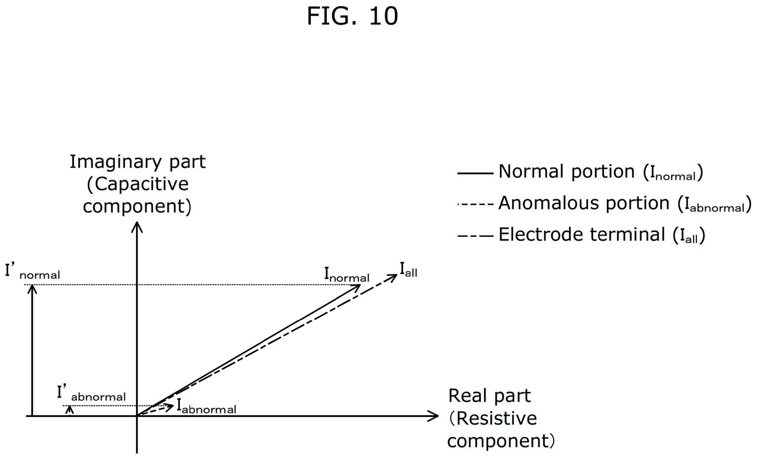

   FIG. 10 illustrates complex numbers obtained by projecting, onto a vertical axis, complex numbers on a complex plane representing AC current flowing through a storage battery according to an embodiment of the present disclosure.
[FIG. 11]

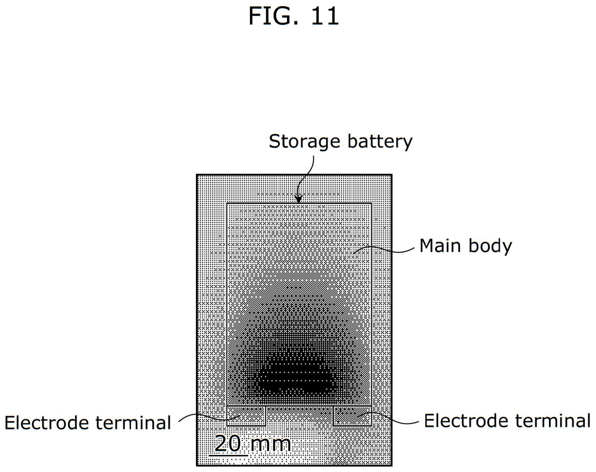

   FIG. 11 illustrates an image generated based on the projected complex numbers illustrated in FIG. 10.
[FIG. 12]

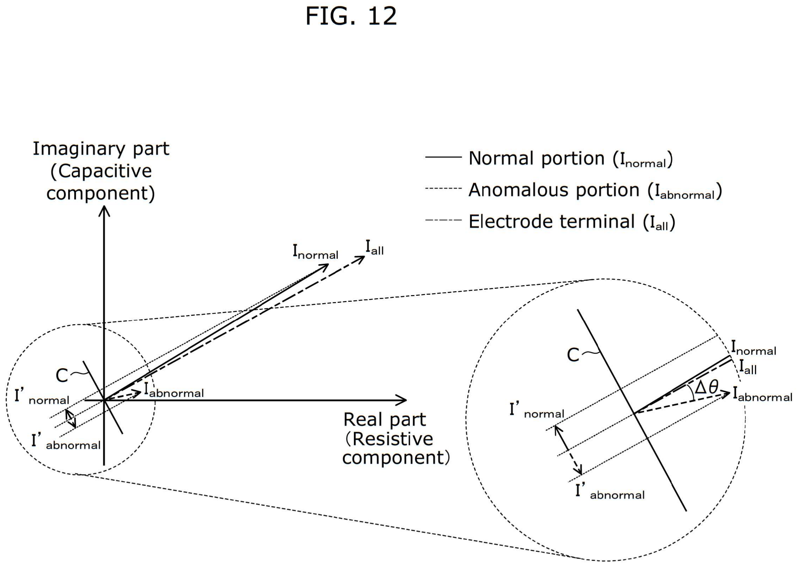

   FIG. 12 illustrates complex numbers obtained by projecting, onto a predetermined straight line, complex numbers on a complex plane representing AC current flowing through a storage battery according to an embodiment of the present disclosure.
[FIG. 13]

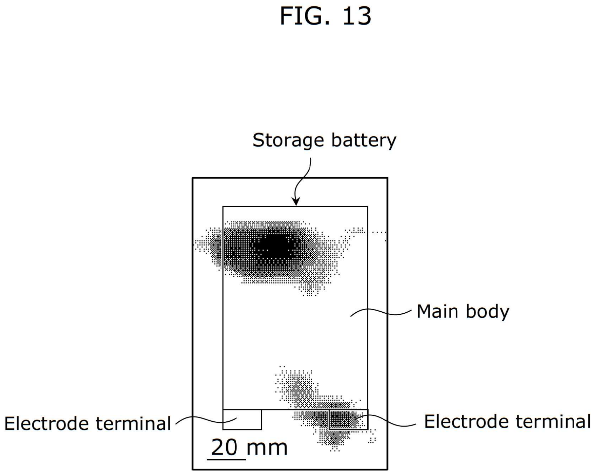

   FIG. 13 illustrates an image generated based on the projected complex numbers illustrated in FIG. 12.

### [Description of Embodiments]

A storage battery inspection device according to one aspect of the present disclosure includes: an application unit configured to apply an alternating current (AC) current to a storage battery; a sensing unit configured to sense a magnetic field external to the storage battery; a calculation unit configured to calculate an AC current flowing through the storage battery based on a sensing result from the sensing unit; and a correction unit configured to calculate, based on a calculation result from the calculation unit, one or more vectors on a complex plane representing the AC current flowing through the storage battery, calculate one or more projection vectors by projecting the one or more vectors calculated onto a predetermined straight line on the complex plane, and output a corrected signal indicating magnitudes of the one or more projection vectors calculated.

This enables calculation of one or more vectors on a complex plane representing AC current flowing in the storage battery, calculation of one or more projection vectors by projecting the one or more vectors onto a predetermined straight line on the complex plane, and output of a corrected signal indicating the magnitudes of the one or more projection vectors. Therefore, when an anomaly occurs in the storage battery, a vector representing AC current flowing through the anomalous portion and a vector representing AC current flowing through the normal portion in the vicinity of that anomalous portion can be calculated. While it would be difficult to distinguish between anomalous portions and normal portions by merely outputting the magnitudes of these vectors, as described above, by calculating projection vectors and outputting their magnitudes, it becomes easy to make the output value indicating the magnitude of AC current at an anomalous portion different from the output value indicating the magnitude of AC current at a normal portion. This makes it easy to distinguish between anomalous portions and normal portions, thus making it possible to more appropriately inspect the storage battery.

For example, the storage battery includes a main body and an electrode terminal connected to the main body, and the predetermined straight line is orthogonal to a vector on the complex plane representing AC current flowing through an entirety of the main body.

This enables output of the magnitudes of one or more projection vectors projected onto a straight line that is orthogonal to a vector on the complex plane representing AC current flowing through the entirety of the main body of the storage battery. For example, the phase of AC current flowing through an anomalous portion in the main body lags behind the phase of AC current flowing through the entirety of the main body, and accordingly, the phase of AC current flowing through a normal portion in the main body leads the phase of AC current flowing through the entirety of the main body. Stated differently, with respect to a vector representing AC current flowing through the entirety of the main body, the direction of a vector representing AC current flowing through the anomalous portion in the main body and the direction of a vector representing AC current flowing through the normal portion in the main body are opposite directions. Therefore, by calculating projection vectors as described above, it is possible to increase the difference between the output value indicating the magnitude of AC current flowing through the anomalous portion in the main body and the output value indicating the magnitude of AC current flowing through the normal portion in the main body, making it even easier to distinguish between anomalous portions and normal portions. This makes it possible to more appropriately inspect storage batteries.

For example, the storage battery inspection device further includes: a generation unit configured to generate an image indicating a distribution of the AC current flowing through the storage battery based on the corrected signal output by the correction unit; and a display unit configured to display the image generated by the generation unit.

This enables display of an image indicating the distribution of AC current flowing through the storage battery, making it easy to understand at which position in the storage battery an anomaly has occurred, and making it possible to more appropriately inspect the storage battery.

For example, a storage battery inspection method according to one aspect of the present disclosure includes: applying, by an application unit, an alternating current (AC) current to a storage battery; sensing, by a sensing unit, a magnetic field external to the storage battery; calculating, by a calculation unit, an AC current flowing through the storage battery based on a sensing result from the sensing unit; and calculating, by a correction unit, based on a calculation result from the calculation unit, one or more vectors on a complex plane representing the AC current flowing through the storage battery, calculating one or more projection vectors by projecting the one or more vectors calculated onto a predetermined straight line on the complex plane, and outputting a corrected signal indicating magnitudes of the one or more projection vectors calculated.

This enables calculation of one or more vectors on a complex plane representing AC current flowing in the storage battery, calculation of one or more projection vectors by projecting the one or more vectors onto a predetermined straight line on the complex plane, and output of a corrected signal indicating the magnitudes of the one or more projection vectors. Therefore, when an anomaly occurs in the storage battery, a vector representing AC current flowing through the anomalous portion and a vector representing AC current flowing through the normal portion in the vicinity of that anomalous portion can be calculated. While it would be difficult to distinguish between anomalous portions and normal portions by merely outputting the magnitudes of these vectors, as described above, by calculating projection vectors and outputting their magnitudes, it becomes easy to make the output value indicating the magnitude of AC current at an anomalous portion different from the output value indicating the magnitude of AC current at a normal portion. This makes it easy to distinguish between anomalous portions and normal portions, thus making it possible to more appropriately inspect the storage battery.

The following describes embodiments with reference to the drawings. Each embodiment described below shows a general or specific example. The numerical values, shapes, materials, elements, the arrangement and connection of the elements, steps, order of the steps, etc., indicated in the following embodiments are mere examples, and therefore do not intend to limit the scope of the claims.

Note that storage batteries are batteries capable of charging and discharging, and are also referred to as secondary batteries. Magnetic field components are components that constitute a magnetic field. Magnetic field components may be components corresponding to spatial positions, may be components corresponding to frequencies, may be components corresponding to predetermined directions, or may be components corresponding to any combination of these. Here, for convenience of explanation, magnetic field components may be simply referred to as magnetic fields.

Moreover, as used herein, "canceling magnetic field components" is not limited to completely canceling magnetic field components, and may be substantially canceling magnetic field components, or partially canceling magnetic field components, etc., and may mean inhibiting magnetic field components.

### [Embodiment]

First, an overview of the storage battery inspection device according to the present embodiment will be given. The storage battery inspection device according to the present embodiment performs non-destructive storage battery inspection. Technical elements such as X-rays, visible light, and microwaves may be used for such non-destructive inspection. However, it is difficult to inspect the electrical state within the storage battery using any of X-rays, visible light, or microwaves. In view of this, the storage battery inspection device according to the present embodiment uses magnetic field information.

More specifically, current flowing within the storage battery generates a magnetic field around the storage battery (external to the storage battery). The relationship between current (J) and magnetic field (H) in a steady state is expressed as ΔH = -(∇×J) based on Maxwell's equations. Based on such a relationship, it is possible to estimate the current flowing within the storage battery from the magnetic field external to the storage battery. The storage battery inspection device according to the present embodiment inspects the electrical state of the storage battery by measuring the magnetic field.

However, during the charging and discharging process of the storage battery, the electrical state within the storage battery changes. Observing the state that changes during the charging and discharging process of the storage battery is useful for inspecting the reliability of the storage battery. However, since measuring the magnetic field takes a considerable amount of time, the electrical state within the storage battery may change while the magnetic field is being measured during the charging and discharging process of the storage battery. When the electrical state within the storage battery changes, the magnetic field also changes, making it difficult to appropriately measure the magnetic field.

In such a situation, it is possible to stop the change in the electrical state within the storage battery by stopping the charging and discharging of the storage battery. However, when charging and discharging is simply stopped, no current flows within the storage battery, and no magnetic field component corresponding to the electrical state within the storage battery is generated. It is therefore not appropriate to measure the magnetic field when charging and discharging is simply stopped.

Magnetic materials may be used in the electrodes and other components of the storage battery. Magnetic field components are also generated by the magnetization of such magnetic materials in the storage battery. The strength of the magnetic field component generated by the magnetization of the magnetic materials in the storage battery may be much greater than the strength of the magnetic field component generated by the current flowing within the storage battery. For example, the strength of the magnetic field component generated by the magnetization of the magnetic materials in the storage battery is assumed to be on the order of several millitesla, and the strength of the magnetic field component generated by the current flowing within the storage battery is assumed to be several microtesla or less.

In such cases, the magnetic sensor for measuring the magnetic field strongly reacts to the magnetic field component generated by the magnetization of the magnetic materials in the storage battery. Therefore, it is difficult to detect with high precision the fine magnetic field components generated by the current flowing within the storage battery.

In view of this, first, the storage battery inspection device according to the present embodiment applies AC current to the storage battery. With this, the storage battery inspection device can cause AC current to flow within the storage battery while suspending (inhibiting) charging and discharging during the charging and discharging process of the storage battery. AC current flowing within the storage battery also generates a magnetic field component external to the storage battery.

Furthermore, the storage battery inspection device according to the present embodiment uses a cancel coil to cancel magnetic field components having frequencies lower than the frequency of the AC current. With this, the storage battery inspection device can cancel the magnetic field component generated by the magnetization of the magnetic materials in the storage battery while maintaining the magnetic field component generated by the AC current applied to the storage battery.

Therefore, the storage battery inspection device according to the present embodiment can appropriately sense the magnetic field component generated by the AC current applied to the storage battery.

The storage battery inspection device according to the present embodiment calculates, based on the sensed magnetic field component, one or more vectors on a complex plane representing AC current flowing in the storage battery, calculates one or more projection vectors by projecting the calculated one or more vectors onto a predetermined straight line, and outputs the magnitudes of the calculated one or more projection vectors. This approach may create a discernible difference between the output value indicating the magnitude of AC current flowing in an anomalous portion in the storage battery and the output value indicating the magnitude of AC current flowing in a normal portion in the vicinity of that portion. This makes it easy to distinguish between anomalous portions and normal portions, thus making it possible to appropriately inspect the electrical state of the storage battery. Below, a specific configuration of the storage battery inspection device according to the present embodiment will be described.

FIG. 1 is a block diagram illustrating the configuration of the storage battery inspection device according to the present embodiment. Storage battery inspection device 10 illustrated in FIG. 1 includes charge control circuit 11, magnetic sensor 12, preamplifier 18, cancel coil 13, feedback circuit 14, high-pass filter (HPF) 19, detection circuit 15, imaging circuit 16, and display 17.

Charge control circuit 11 is a circuit that applies voltage and current to the storage battery. More specifically, charge control circuit 11 applies AC current to the storage battery by applying to the storage battery an external voltage in which AC voltage is superimposed on direct current (DC) voltage for balancing against the output voltage of the storage battery. In the present embodiment, charge control circuit 11 corresponds to the application unit.

Magnetic sensor 12 is a sensor that senses magnetic field components. More specifically, magnetic sensor 12 senses magnetic field components external to the storage battery and outputs a magnetic sensor signal indicating the sensed magnetic field components. For example, the strength of the magnetic sensor signal output from magnetic sensor 12 is proportional to the strength of the magnetic field components sensed by magnetic sensor 12. In the present embodiment, magnetic sensor 12 corresponds to the sensing unit.

Preamplifier 18 is a circuit that amplifies weak signals. With this, a signal usable by downstream circuits (feedback circuit 14, high-pass filter 19, etc.) is obtained. For example, preamplifier 18 amplifies the magnetic sensor signal output from magnetic sensor 12 and outputs the amplified magnetic sensor signal. In the present disclosure, the magnetic sensor signal output from magnetic sensor 12 may be a magnetic sensor signal that is output from magnetic sensor 12 and amplified by preamplifier 18.

Cancel coil 13 is a circuit that generates magnetic field components based on input current. More specifically, cancel coil 13 generates magnetic field components based on input current to cancel the magnetic field components generated by the magnetization of the magnetic materials in the storage battery.

Feedback circuit 14 is a circuit that applies current as input current to cancel coil 13 based on the magnetic sensor signal output from magnetic sensor 12. More specifically, feedback circuit 14 obtains a low-frequency signal indicating magnetic field components having frequencies lower than the frequency of the AC current from the magnetic sensor signal output from magnetic sensor 12 in a state where the AC current is applied to the storage battery.

For example, the strength of the low-frequency signal is proportional to the strength of the magnetic field components having frequencies lower than the frequency of the AC current. The low-frequency signal may indicate magnetic field components of all frequencies lower than the frequency of the AC current, or the low-frequency signal may indicate magnetic field components of some frequencies lower than the frequency of the AC current. More specifically, the low-frequency signal may indicate magnetic field components having frequencies lower than a reference frequency that is lower than the frequency of the AC current. The low-frequency signal may indicate magnetic field components corresponding to DC components.

Feedback circuit 14 then applies current as input current to cancel coil 13 based on the low-frequency signal. More specifically, feedback circuit 14 applies a larger input current to cancel coil 13 the larger the low-frequency signals obtained from the magnetic sensor signal is, that is, the larger the magnetic field components having frequencies lower than the frequency of the AC current are.

High-pass filter 19 is a filter that blocks frequency components lower than the cutoff frequency and passes frequency components higher than the cutoff frequency. A frequency lower than the frequency of the AC current applied to storage battery 31 is used as the cutoff frequency of high-pass filter 19. With this, frequency components that are lower than the frequency of the AC current applied to storage battery 31 and lower than the cutoff frequency are removed from the magnetic sensor signal.

Note that here, blocking frequency components lower than the cutoff frequency means inhibiting the passage of frequency components lower than the cutoff frequency, and is not limited to completely blocking frequency components lower than the cutoff frequency. Similarly, passing frequency components higher than the cutoff frequency means inhibiting the blocking of frequency components higher than the cutoff frequency, and is not limited to completely passing frequency components higher than the cutoff frequency. The degree of blocking and passing depends on the quality of high-pass filter 19.

High-pass filter 19 may block components at the same frequency as the cutoff frequency, may pass them, or may block some components at the same frequency as the cutoff frequency while passing other components.

In the present disclosure, the magnetic sensor signal output from magnetic sensor 12 may be a magnetic sensor signal that is output from magnetic sensor 12 and from which low-frequency components are removed by high-pass filter 19. This magnetic sensor signal is input to detection circuit 15.

Detection circuit 15 is a circuit that performs detection, for example, phase detection. More specifically, detection circuit 15 obtains a signal indicating magnetic field components having the same frequency as the frequency of the AC current applied to the storage battery as a detection signal. More specifically, detection circuit 15 obtains a detection signal indicating magnetic field components having the same frequency as the frequency of the AC current from the magnetic sensor signal output from magnetic sensor 12 in a state where the AC current is applied to the storage battery and the input current is applied to cancel coil 13.

For example, the strength of the detection signal is proportional to the strength of the magnetic field components having the same frequency as the frequency of the AC current.

Imaging circuit 16 includes calculation unit 76, correction unit 77, and generation unit 78, and is a circuit that generates images. More specifically, imaging circuit 16 generates an image indicating the state of the storage battery based on the detection signal from detection circuit 15. In this context, the term "image" may also refer to video.

Calculation unit 76 calculates AC current flowing through the storage battery based on the sensing results from magnetic sensor 12. More specifically, magnetic sensor 12 senses magnetic field components at each of a plurality of positions external to the storage battery, and calculation unit 76 calculates AC current flowing through each of a plurality of positions internal to the storage battery by calculating AC current based on the magnetic field components at each of the plurality of external positions. Calculation unit 76 obtains the sensing results from magnetic sensor 12 via detection circuit 15 or the like.

Based on the calculation results from calculation unit 76, correction unit 77 calculates one or more vectors on a complex plane representing AC current flowing through the storage battery. Correction unit 77 calculates one or more projection vectors by projecting the calculated one or more vectors onto a predetermined straight line on the complex plane, and outputs a corrected signal indicating the magnitudes of the calculated one or more projection vectors.

Generation unit 78 generates an image indicating the distribution of AC current flowing through the storage battery based on the corrected signal output by correction unit 77.

Display 17 is a device (information display circuit) that displays the image generated by generation unit 78. More specifically, display 17 includes a screen and displays the image generated by imaging circuit 16 on the screen. In the present embodiment, display 17 corresponds to the display unit.

Storage battery inspection device 10 may include only a portion of charge control circuit 11, magnetic sensor 12, cancel coil 13, feedback circuit 14, detection circuit 15, imaging circuit 16, and display 17. Stated differently, storage battery inspection device 10 need not include all of these. For example, display 17 may be included in a device different from storage battery inspection device 10, or imaging circuit 16 and display 17 may be included in a device different from storage battery inspection device 10.

Storage battery inspection device 10 need not include preamplifier 18, high-pass filter 19, or both of these. For example, the magnetic sensor signal output from magnetic sensor 12 may be input to feedback circuit 14 and detection circuit 15 without passing through preamplifier 18 or high-pass filter 19.

Storage battery inspection device 10 may be configured such that two or more of the plurality of elements constituting storage battery inspection device 10 are configured as a single circuit. Moreover, these circuits are not limited to dedicated circuits and may be general-purpose circuits. In particular, the circuit that performs information processing may be a general-purpose circuit such as a processor that executes a program or the like corresponding to the above processing.

FIG. 2 is a flowchart illustrating an operation of storage battery inspection device 10 illustrated in FIG. 1. More specifically, the plurality of elements of storage battery inspection device 10 illustrated in FIG. 1 perform the operation illustrated in FIG. 2.

First, charge control circuit 11 applies AC current having frequency f₀ to the storage battery (S11). More specifically, charge control circuit 11 applies AC current to the storage battery by applying to the storage battery an external voltage in which AC voltage is superimposed on DC voltage for balancing against the output voltage of the storage battery.

Magnetic sensor 12 senses magnetic field components in a state where AC current is applied to the storage battery and outputs a magnetic sensor signal indicating the sensed magnetic field components (S12).

Feedback circuit 14 obtains a low-frequency signal having a frequency lower than frequency f₀ from the magnetic sensor signal (S13). More specifically, feedback circuit 14 obtains a low-frequency signal indicating magnetic field components having frequencies lower than frequency f₀ of the AC current from the magnetic sensor signal output from magnetic sensor 12.

Feedback circuit 14 then applies current as input current to cancel coil 13 based on the low-frequency signal having a frequency lower than frequency f₀ (S14).

Cancel coil 13 generates magnetic field components based on input current. More specifically, cancel coil 13 generates low-frequency magnetic field components having frequencies lower than frequency f₀ and cancels low-frequency components having frequencies lower than frequency f₀ among the magnetic field applied to magnetic sensor 12 (S15).

Detection circuit 15 obtains detection signal having frequency f₀ from the magnetic sensor signal (S16). More specifically, detection circuit 15 obtains a detection signal indicating magnetic field components having the same frequency as frequency f₀ of the AC current from the magnetic sensor signal output from magnetic sensor 12.

Charge control circuit 11, magnetic sensor 12, cancel coil 13, feedback circuit 14, and detection circuit 15 continuously perform the above processing in parallel. Magnetic sensor 12 then senses magnetic field components at each of a plurality of positions around the storage battery in a state where AC current is applied to the storage battery and input current is applied to cancel coil 13, and outputs a magnetic sensor signal indicating the sensed magnetic field components.

Detection circuit 15 obtains a magnetic sensor signal output from magnetic sensor 12 at each of a plurality of positions around the storage battery in a state where AC current is applied to the storage battery and input current is applied to cancel coil 13, and obtains a detection signal from the magnetic sensor signal.

Calculation unit 76 of imaging circuit 16 calculates AC current flowing through the storage battery based on the sensing results from magnetic sensor 12 and the like (S17).

Correction unit 77 of imaging circuit 16 calculates one or more vectors on a complex plane representing AC current calculated by calculation unit 76 (S18), calculates one or more projection vectors by projecting the calculated one or more vectors onto a predetermined straight line on the complex plane (S19), and outputs a corrected signal indicating the magnitudes of the calculated one or more projection vectors (S20).

Generation unit 78 of imaging circuit 16 generates an image based on the output corrected signal (S21).

Display 17 then displays the generated image (S22).

FIG. 3 is a conceptual diagram illustrating a specific configuration of storage battery inspection device 10 illustrated in FIG. 1. FIG. 3 illustrates storage battery inspection device 10 and storage battery 31. Storage battery inspection device 10 illustrated in FIG. 3 corresponds to a specific example of storage battery inspection device 10 illustrated in FIG. 1, and includes measurement unit 21, power supply unit 23, display 17, and information processing unit 24.

For example, charge control circuit 11 is included in power supply unit 23, and imaging circuit 16 is included in information processing unit 24. Each of feedback circuit 14 and detection circuit 15 may be included in measurement unit 21, may be included in information processing unit 24, or may be distributed between measurement unit 21 and information processing unit 24.

Measurement unit 21 includes magnetic sensor 12 as a probe, and includes cancel coil 13 in the vicinity of magnetic sensor 12. Measurement unit 21 then measures the magnetic field via magnetic sensor 12. Measurement unit 21 also includes a slidable mechanism configured using an actuator or the like. With this, measurement unit 21 can scan the vicinity of storage battery 31 using magnetic sensor 12.

Measurement unit 21 also includes turntable 22. Turntable 22 is a platform for placing storage battery 31, which is the inspection target, and includes a rotatable mechanism configured using an actuator or the like. With this, measurement unit 21 can scan the vicinity of storage battery 31 at various rotation angles using magnetic sensor 12.

For example, magnetic sensor 12 is positioned inside cancel coil 13, and as magnetic sensor 12 moves, cancel coil 13 also moves.

Although storage battery 31 is rotated by turntable 22 in this example, measurement unit 21 may scan the vicinity of storage battery 31 at various rotation angles by rotating around storage battery 31. Measurement unit 21 may also rotate magnetic sensor 12.

Power supply unit 23 is a device that applies voltage and current to storage battery 31. More specifically, power supply unit 23 applies AC current to storage battery 31 by applying to storage battery 31 an external voltage in which AC voltage is superimposed on DC voltage for balancing against the output voltage of storage battery 31. Power supply unit 23 may be a function generator. In the example of FIG. 3, power supply unit 23 applies voltage and current to storage battery 31 via conducting wires.

Information processing unit 24 is a device that performs information processing. For example, information processing unit 24 is a computer.

More specifically, information processing unit 24 may apply current as input current to cancel coil 13 based on the magnetic sensor signal output from magnetic sensor 12 via measurement unit 21 or the like. At that time, information processing unit 24 may obtain a low-frequency signal indicating magnetic field components having frequencies lower than the frequency of the AC current from the magnetic sensor signal output from magnetic sensor 12 in a state where the AC current is applied to storage battery 31. Information processing unit 24 may then apply current as input current to cancel coil 13 based on the low-frequency signal.

For example, information processing unit 24 may perform detection processing. More specifically, information processing unit 24 obtains a detection signal indicating magnetic field components having the same frequency as the frequency of the AC current from the magnetic sensor signal output from magnetic sensor 12 in a state where the AC current is applied to storage battery 31 and the input current is applied to cancel coil 13.

For example, information processing unit 24 may calculate AC current flowing through storage battery 31 based on the magnetic field external to storage battery 31. For example, information processing unit 24 may calculate one or more vectors on a complex plane representing the calculated AC current, and calculate one or more projection vectors by projecting the one or more vectors onto a predetermined straight line on the complex plane.

For example, information processing unit 24 may generate an image indicating the state of storage battery 31 based on the magnitude of one or more projection vectors. Information processing unit 24 may display the generated image on display 17.

Storage battery 31 inspected by storage battery inspection device 10 is, for example, a lithium battery or lithium-ion battery. Storage battery 31 includes a pair of electrode terminals 32 and 33. Each of electrode terminals 32 and 33 and power supply unit 23 are connected via conducting wires. Measurement unit 21 then measures the magnetic field via magnetic sensor 12 in a state in which AC current is applied to storage battery 31 by power supply unit 23.

Note that the specific example of storage battery inspection device 10 illustrated in FIG. 1 is not limited to the example in FIG. 3. For example, some elements may be omitted, or other elements may be added. Some or all of measurement unit 21, power supply unit 23, display 17, and information processing unit 24 illustrated in FIG. 3 may have an integrated structure.

FIG. 4 is a conceptual diagram illustrating the specific structure of magnetic sensor 12 illustrated in FIG. 3. Magnetic sensor 12 is configured using a tunneling magneto resistive (TMR) element.

In the TMR element, an insulating film is sandwiched between magnetic films having a thickness of approximately 10 nm to 100 nm. More specifically, the TMR element includes a plurality of thin films, namely soft layer 25, tunnel layer 26, and PIN layer (magnetization pinned layer) 27. Soft layer 25 is a magnetic film whose magnetization direction varies according to the direction of external magnetization. PIN layer 27 is a magnetic film whose magnetization direction does not vary. Tunnel layer 26 is an insulating film.

The electrical resistance differs between when the magnetization direction in soft layer 25 and the magnetization direction in PIN layer 27 are the same and when those directions are different. The magnetic field component is sensed by utilizing this change in electrical resistance.

For example, magnetic sensor 12 utilizes the above-described characteristics to sense and measure magnetic field components. Note that magnetic sensor 12 is not limited to the above example of a TMR element, and may be configured using other elements such as a giant magneto resistive (GMR) element or a superconducting quantum interference device (SQUID) element.

FIG. 5 is a conceptual diagram illustrating a state in which storage battery 31 illustrated in FIG. 3 is being inspected. Storage battery 31 illustrated in FIG. 5 includes main body 79 and a pair of electrode terminals 32 and 33 connected to main body 79. Main body 79 includes a pair of electrode plates 34 and 35, electrolyte 37, and metal package 38. The pair of electrode plates 34 and 35 and electrolyte 37 are covered by metal package 38.

For example, magnetic sensor 12 senses magnetic field components at each of a plurality of positions on scanning target surface 41 above storage battery 31 placed on turntable 22. Scanning target surface 41 is also referred to as a measurement surface. Magnetic sensor 12 may sequentially move to a plurality of positions on scanning target surface 41 and sense magnetic field components. With this, information on magnetic field components of scanning target surface 41 is obtained.

For example, magnetic sensor 12 may sense magnetic field components at each of a plurality of positions on each of a plurality of scanning target surfaces 41. More specifically, magnetic sensor 12 may sense magnetic field components at each of a plurality of positions on one scanning target surface 41, and thereafter, may sense magnetic field components at each of a plurality of positions on another scanning target surface 41. With this, information on the magnetic field of each scanning target surface 41 is obtained.

Furthermore, information on the magnetic field of reconstruction target surface 42, which is different from these scanning target surfaces 41, may be calculated from information on the magnetic fields of the plurality of scanning target surfaces 41. For example, reconstruction target surface 42 may be a surface corresponding to the upper surface of electrode plate 34. More specifically, information on the magnetic field of reconstruction target surface 42 may be calculated using information on the magnetic fields of the plurality of scanning target surfaces 41 and Maxwell's equations. Conductivity distribution in storage battery 31 and AC current flowing through storage battery 31, etc., may be calculated using information on the magnetic field of scanning target surface 41 or reconstruction target surface 42 and Maxwell's equations.

The calculation processing described above may be performed by information processing unit 24 of FIG. 3, or may be performed by other elements.

Current flowing within storage battery 31 generates a magnetic field component external to storage battery 31. Magnetic sensor 12 senses a magnetic field component that current flowing within storage battery 31 generates external to storage battery 31. If the current flowing within storage battery 31 changes, the magnetic field component external to storage battery 31 also changes. Stated differently, current flowing within storage battery 31 can be calculated using the magnetic field component external to storage battery 31.

For example, during the charging and discharging process of storage battery 31, metal may precipitate on electrode plate 34 or electrode plate 35, causing dendrite 36 to occur and grow within storage battery 31.

The conductivity of dendrite 36 is higher than the conductivity of electrolyte 37. Therefore, if dendrite 36 occurs within storage battery 31, the electrical state within storage battery 31 changes. With this, the magnetic field component external to storage battery 31 also changes. For example, storage battery inspection device 10 can inspect the state of occurrence and growth of dendrite 36 by sensing the magnetic field component external to storage battery 31.

However, as dendrite 36 occurs and grows, the electrical state within storage battery 31 changes, so the magnetic field component external to storage battery 31 also changes. Sensing magnetic field components at a plurality of positions external to storage battery 31 takes time, and it is not easy to sense magnetic field components that change over time over a wide range and with high resolution.

By stopping charging and discharging of storage battery 31, occurrence and growth of dendrite 36 are inhibited, and changes in the electrical state within storage battery 31 are also inhibited. However, when charging and discharging of storage battery 31 is stopped, a magnetic field component based on the electrical state inside storage battery 31 is also not generated. Therefore, in this state, it is difficult to inspect the state of occurrence and growth of dendrite 36.

Therefore, storage battery inspection device 10 applies AC current to storage battery 31 by applying to storage battery 31 an external voltage in which AC voltage is superimposed on DC voltage for balancing against the output voltage of storage battery 31. With this, AC current flows in storage battery 31 in a state where occurrence and growth of dendrite 36 are inhibited. AC current flowing in storage battery 31 generates a magnetic field component based on the electrical state inside storage battery 31.

Storage battery inspection device 10 can inspect the state of occurrence and growth of dendrite 36 by sensing the magnetic field component generated by the AC current flowing through storage battery 31. Storage battery inspection device 10 can extract the magnetic field component based on the electrical state inside storage battery 31 by extracting the magnetic field component corresponding to the frequency of the AC current. Therefore, storage battery inspection device 10 can appropriately inspect the electrical state inside storage battery 31.

However, when the frequency of the AC current is high, the magnetic field component generated by the AC current is shielded by the shielding portions such as electrode plates 34 and 35 and metal package 38, and does not leak to the exterior of storage battery 31. Therefore, for example, a frequency lower than a predetermined frequency is used for the AC voltage and AC current. Here, the predetermined frequency is 1/(πσₛµₛdₛ²) when the conductivity of the shielding portion is σₛ, the magnetic permeability of the shielding portion is µₛ, and the thickness of the shielding portion is dₛ. With this, a magnetic field component is generated external to storage battery 31.

Note that, in order to inhibit the effects of charging and discharging and shorten the measurement time of the magnetic field component corresponding to the frequency of the AC current, a frequency that is lower than the predetermined frequency and higher than 1/2 of the predetermined frequency may be used. Alternatively, a frequency that is lower than the predetermined frequency and higher than 1/10 of the predetermined frequency may be used. However, in order to more reliably generate a magnetic field component external to storage battery 31, a frequency that is lower than 1/2 of the predetermined frequency may be used, or a frequency that is lower than 1/10 of the predetermined frequency may be used.

Next, a more specific configuration for applying an AC voltage to storage battery 31 will be described with reference to FIG. 6. FIG. 6 illustrates a circuit for applying an AC voltage to storage battery 31 illustrated in FIG. 3.

FIG. 6 illustrates storage battery 31 and charge control circuit 11. Furthermore, capacitor C_{b}, electromotive force vₒ, internal resistance γ_{b}, DC voltage vₑ, AC voltage vₐcosωt, and external resistance γ are illustrated. Capacitor C_{b}, electromotive force vₒ, and internal resistance γ_{b} are included in storage battery 31. DC voltage vₑ and AC voltage vₐcosωt are included in charge control circuit 11. In AC voltage vₐcosωt, t represents time, and ω in AC voltage vₐcosωt represents angular frequency.

Charge control circuit 11 applies to storage battery 31 external voltage v_{E}(t) = vₑ + vₐcosωt in which AC voltage vₐcosωt is superimposed on DC voltage vₑ = vₒ(T) for balancing against output voltage vₒ(T) of storage battery 31 at predetermined time t = T in the charging and discharging process. For example, external voltage v_{E}(t) is obtained by external modulation bias (external modulation circuit and bias circuit).

Stated differently, charge control circuit 11 repeats charging and discharging at angular frequency ω in a state balanced against output voltage vₒ(T) of storage battery 31. Magnetic sensor 12 measures a magnetic field corresponding to a response component of charging and discharging repeated at angular frequency ω.

However, storage battery 31 is assumed to have a shielding portion that prevent current inside storage battery 31 from generating a magnetic field external to storage battery 31. For example, when frequency f (f=ω/2π) of AC voltage vₐ cosωt is high, the magnetic field is shielded by a shielding portion such as electrode plates 34 and 35 and metal package 38, and does not leak to the exterior of storage battery 31.

Therefore, charge control circuit 11 superimposes, on DC voltage vₑ, AC voltage vₐcosωt corresponding to a frequency lower than a frequency determined based on the conductivity of the shielding portion, the magnetic permeability of the shielding portion, and the thickness (depth) of the shielding portion. More specifically, when the conductivity of the shielding portion is expressed as σ, the magnetic permeability of the shielding portion is expressed as µ, and the thickness of the shielding portion is expressed as d, charge control circuit 11 superimposes AC voltage vₐcosωt corresponding to frequency f that satisfies f<1/(πσµd²). Note that thickness d of the shielding portion is, for example, the sum of the thickness of electrode plate 34 and the thickness of metal package 38.

After measuring the magnetic field, charge control circuit 11 stops superimposing the AC voltage and performs control so that only one of charging and discharging is performed. For example, charge control circuit 11 applies a DC voltage greater than the output voltage of storage battery 31 to charge storage battery 31. Alternatively, charge control circuit 11 applies a DC voltage smaller than the output voltage of storage battery 31 to discharge storage battery 31. Alternatively, charge control circuit 11 may discharge storage battery 31 without applying a voltage.

Based on the above configuration, during the charging and discharging process, charge control circuit 11 intermittently applies an external voltage in which AC voltage is superimposed on DC voltage for balancing against the output voltage of storage battery 31. Charge control circuit 11 may apply the external voltage on which AC voltage is superimposed periodically (cyclically), or may apply it irregularly. Charge control circuit 11 may apply the external voltage on which AC voltage is superimposed automatically, or may apply it based on manual operation. Magnetic sensor 12 measures a magnetic field around storage battery 31 in a state where an external voltage on which AC voltage is superimposed is applied.

For example, each of measurement times for measuring the magnetic field in the charging and discharging process may be predetermined. In such cases, charge control circuit 11 applies an external voltage on which AC voltage is superimposed to storage battery 31 at each predetermined time in the charging and discharging process. Magnetic sensor 12 then measures the magnetic field at each predetermined time in the charging and discharging process. After measurement, charge control circuit 11 performs control so that normal charging and discharging are performed. With this, storage battery inspection device 10 can measure the magnetic field corresponding to each predetermined time in the charging and discharging process.

Each of measurement times for measuring the magnetic field in the charging and discharging process may be determined based on characteristics of the output voltage of storage battery 31, or may be determined based on characteristics of time. Stated differently, storage battery inspection device 10 may measure the magnetic field at each predetermined output voltage, or may measure the magnetic field at each predetermined time interval.

Imaging circuit 16 then may generate a plurality of images corresponding to a plurality of times in the charging and discharging process, each indicating a magnetic field distribution or current distribution. Furthermore, imaging circuit 16 may generate a video (moving image) that includes a plurality of images and indicates changes in magnetic field distribution or current distribution by connecting the generated plurality of images. Display 17 then may display a video indicating changes in magnetic field distribution or current distribution. This enables a user of storage battery inspection device 10 to accurately observe the growth process of dendrite 36.

Note that charge control circuit 11 and magnetic sensor 12 may operate in conjunction using a synchronization signal. Stated differently, the superposition of AC voltage and the measurement of the magnetic field may be controlled to start simultaneously and end simultaneously by a synchronization signal.

FIG. 7 is a conceptual diagram illustrating the overall configuration of storage battery inspection device 10 illustrated in FIG. 1. Charge control circuit 11 applies a superimposed voltage of AC voltage and DC voltage to storage battery 31. Here, the DC voltage is a voltage for balancing against the output voltage of storage battery 31 (also called open-circuit voltage), and is an offset voltage for maintaining the state of charge of storage battery 31. More specifically, the magnitude of the DC voltage is the same as the magnitude of the output voltage of storage battery 31. With this, charging and discharging of storage battery 31 is inhibited.

By applying a superimposed voltage of AC voltage and DC voltage to storage battery 31, AC current is applied to storage battery 31. For example, AC current of approximately 0.1 Hz to 10 Hz is applied to storage battery 31. The AC current applied to storage battery 31 generates a magnetic field component external to storage battery 31.

Magnetic sensor 12 senses the magnetic field component generated external to storage battery 31. Magnetic sensor 12 scans on a two-dimensional plane perpendicular to the direction toward storage battery 31.

However, residual magnetization of magnetic materials included in storage battery 31 also generates a magnetic field component external to storage battery 31. When magnetic sensor 12 is affected by the magnetic field component generated by residual magnetization of magnetic materials included in storage battery 31, it becomes difficult to appropriately sense the magnetic field component generated by the AC current applied to storage battery 31.

Therefore, cancel coil 13 generates magnetic field components based on input current to cancel the magnetic field components generated by residual magnetization. Here, the input current is current applied to cancel coil 13 by feedback circuit 14. This input current is also called feedback current.

Feedback circuit 14 includes signal processing circuit 51 and current amplification circuit 52. Signal processing circuit 51 obtains the magnetic sensor signal output from magnetic sensor 12 and amplified by preamplifier 18, and outputs a control signal to current amplification circuit 52. For example, signal processing circuit 51 obtains a low-frequency signal indicating magnetic field components having frequencies lower than the frequency of the AC current from the magnetic sensor signal. Signal processing circuit 51 then outputs a control signal indicating the magnitude of feedback current to be applied to cancel coil 13 based on the low-frequency signal.

More specifically, signal processing circuit 51 outputs a control signal indicating a feedback current magnitude that increases proportionally with the magnetic field component at frequencies lower than the AC current frequency, as indicated by the low-frequency signal.

Current amplification circuit 52 applies feedback current having the magnitude indicated by the control signal output from signal processing circuit 51 to cancel coil 13. With this, magnetic field components for canceling the magnetic field components generated by residual magnetization are generated based on magnetic field components having frequencies lower than the frequency of the AC current.

The magnetic field components generated by residual magnetization are assumed to be composed of magnetic field components having frequencies lower than the frequency of the AC current. Therefore, storage battery inspection device 10 can generate magnetic field components equivalent to the magnetic field components generated by residual magnetization by generating magnetic field components based on magnetic field components having frequencies lower than the frequency of the AC current. Storage battery inspection device 10 can thus appropriately cancel the magnetic field components generated by residual magnetization.

Detection circuit 15 obtains the magnetic sensor signal from magnetic sensor 12. For example, detection circuit 15 obtains the magnetic sensor signal, which has been amplified and removed of low-frequency components, from magnetic sensor 12 via preamplifier 18 and high-pass filter 19. Detection circuit 15 obtains the reference signal from charge control circuit 11. Here, the reference signal indicates the voltage or current applied to storage battery 31.

More specifically, the reference signal may be an AC voltage superimposed on the DC voltage in charge control circuit 11, or an analog signal having the same frequency and phase as the AC current applied to storage battery 31. The reference signal may be the same as the AC signal applied to storage battery 31. Stated differently, the reference signal may be an analog signal having the same voltage and current as the voltage and current applied to storage battery 31. Alternatively, the reference signal may be an analog signal or digital signal indicating information about the voltage or current applied to storage battery 31.

Based on the magnetic sensor signal and the reference signal, detection circuit 15 obtains a signal indicating magnetic field components having the same frequency as the frequency of the AC current applied to storage battery 31 as a detection signal.

Calculation unit 76 obtains the detection signal from detection circuit 15. Calculation unit 76 calculates AC current flowing through the storage battery based on the detection signal and the like.

Correction unit 77 obtains information indicating the AC current calculated by calculation unit 76. More specifically, correction unit 77 obtains information indicating the magnitude and phase of the AC current calculated by calculation unit 76. Based on the obtained information, correction unit 77 represents the AC current flowing through storage battery 31 as a vector on a complex plane, and calculates a projection vector by projecting the vector onto a predetermined straight line. Correction unit 77 outputs a corrected signal indicating the magnitude of the calculated projection vector.

Generation unit 78 obtains the corrected signal from correction unit 77. Generation unit 78 generates an image indicating the state of storage battery 31 based on the obtained corrected signal. In the present embodiment, this image indicates the distribution of AC current flowing through storage battery 31 as the state of storage battery 31. Note that this image may indicate magnetic field components near the surface of storage battery 31, or the conductivity distribution of storage battery 31, etc., as the state of storage battery 31. Imaging circuit 16 then outputs an image signal indicating the generated image to display 17.

Display 17 displays an image indicating the state of storage battery 31 based on the image signal output from imaging circuit 16.

FIG. 8 is a block diagram illustrating the configuration of detection circuit 15 illustrated in FIG. 7. In the example of FIG. 8, detection circuit 15 includes direct injection box (DI) 71, analog-to-digital converter (ADC) 72, mixer 73, and low-pass filter 74, and performs phase detection. Note that here, an example of phase detection is illustrated, but detection circuit 15 may obtain the detection signal by other methods.

DI 71 is an impedance converter. More specifically, DI 71 obtains the reference signal output from charge control circuit 11, adjusts the ratio of voltage and current of the reference signal, and generates a base signal for phase detection. For example, the base signal is generated as a digital signal.

ADC 72 is a converter for converting analog signals to digital signals. A 16-bit AD converter or the like may be used as ADC 72. ADC 72 obtains the magnetic sensor signal output from magnetic sensor 12 as an analog signal, and converts the magnetic sensor signal obtained as an analog signal to a digital signal.

Mixer 73 is a circuit that mixes a plurality of signals. More specifically, mixer 73 performs multiplication of the base signal generated by DI 71 and the magnetic sensor signal converted to a digital signal by ADC 72, and outputs the result of the multiplication as a multiplication result signal. The DC component of the multiplication result signal corresponds to the magnetic field component having the same frequency as the frequency of the AC current.

Low-pass filter 74 is a filter that blocks frequency components higher than the cutoff frequency and passes frequency components lower than the cutoff frequency. Low-pass filter 74 obtains the multiplication result signal, blocks the AC component of the multiplication result signal, and passes the DC component of the multiplication result signal. With this, low-pass filter 74 outputs a detection signal corresponding to the magnetic field component having the same frequency as the frequency of the AC current.

Detection circuit 15 stores the detection signal in storage circuit 75. In the above example, a digital circuit method is applied to detection circuit 15, but an analog circuit method may be applied to detection circuit 15. Stated differently, detection circuit 15 may obtain a detection signal indicating magnetic field components having the same frequency as the AC current by performing detection processing on the magnetic sensor signal while maintaining it as an analog signal.

Imaging circuit 16 generates an image indicating the state of storage battery 31 based on the detection signal stored in storage circuit 75. Hereinafter, image generation by imaging circuit 16 will be described with reference to FIG. 9 through FIG. 13.

FIG. 9 is a conceptual diagram illustrating AC current flowing through storage battery 31 according to the embodiment. FIG. 10 illustrates complex numbers (one or more projection vectors) obtained by projecting, onto the vertical axis, complex numbers (one or more vectors) on a complex plane representing AC current flowing through storage battery 31 according to the embodiment. FIG. 11 illustrates an image generated based on the projected complex numbers (one or more projection vectors) illustrated in FIG. 10. FIG. 12 illustrates complex numbers (one or more projection vectors) obtained by projecting, onto a predetermined straight line, complex numbers (one or more vectors) on a complex plane representing AC current flowing through a storage battery according to the embodiment. FIG. 13 illustrates an image generated based on the projected complex numbers (one or more projection vectors) illustrated in FIG. 12.

As illustrated in FIG. 9, when AC current is applied to storage battery 31 by charge control circuit 11, AC current flows through storage battery 31. More specifically, AC current input from one electrode terminal 32 (see arrow A in FIG. 9) is output from the other electrode terminal 33 through various paths inside main body 79 (see arrow B in FIG. 9). AC current flowing through the entirety of main body 79 is approximately equal to AC current flowing through electrode terminal 32 and is also approximately equal to AC current flowing through electrode terminal 33.

Magnetic sensor 12 senses the magnetic field at a plurality of positions external to storage battery 31 as it moves relative to storage battery 31. Note that a plurality of magnetic sensors 12 may be used to sense the magnetic field at a plurality of positions external to storage battery 31.

Calculation unit 76 calculates AC current flowing through each of a plurality of positions in storage battery 31 using the magnetic field sensed by magnetic sensor 12. More specifically, calculation unit 76 calculates the magnitude and phase of AC current flowing through each of a plurality of positions in storage battery 31.

The phase of AC current flowing through each of a plurality of positions in main body 79 is in principle equal to AC current flowing through electrode terminal 32 or 33. However, when an anomaly such as dendrite 36 formation occurs inside main body 79, the phase of AC current flowing through the anomalous portion in main body 79 (see dashed arrow in FIG. 9) shifts relative to the phase of AC current flowing through electrode terminal 32 or 33. More specifically, the phase of AC current flowing through the anomalous portion in main body 79 lags behind the phase of AC current flowing through electrode terminal 32 or 33.

Accordingly, the phase of AC current flowing through the normal portion in main body 79 also shifts relative to the phase of AC current flowing through electrode terminal 32 or 33. More specifically, the phase of AC current flowing through the normal portion in main body 79 leads the phase of AC current flowing through electrode terminal 32 or 33.

Note that the magnitude of AC current flowing through the anomalous portion in main body 79 and the magnitude of AC current flowing through the normal portion in the vicinity of that anomalous portion are approximately equal.

As illustrated in FIG. 10, based on the calculation results from calculation unit 76, correction unit 77 calculates one or more vectors on a complex plane representing AC current flowing through storage battery 31. In FIG. 10, the vertical axis is the capacitive component (Imaginary part), and the horizontal axis is the resistive component (Real part). On the complex plane, the length of a vector represents the magnitude of AC current, and the angle between the vector and the horizontal axis represents the phase of AC current. For example, calculation unit 76 calculates the effective value (magnitude) and phase of AC current, and correction unit 77 calculates one or more vectors on a complex plane representing AC current flowing through storage battery 31 based on the effective value and phase of AC current calculated by calculation unit 76.

Here, correction unit 77 calculates vector Iₐₗₗ representing AC current flowing through the entirety of main body 79, that is, AC current flowing through electrode terminal 32 or 33, vector I_{abnormal} representing AC current flowing through the anomalous portion in main body 79, and vector Iₙₒᵣₘₐₗ representing AC current flowing through the normal portion in main body 79.

Vector I_{abnormal} is a vector obtained by adding together one or more vectors representing AC current flowing through each of one or more anomalous portions in main body 79. For example, when two anomalous portions exist in main body 79, a vector obtained by adding together a vector representing AC current flowing through one of the two anomalous portions and a vector representing AC current flowing through the other one of the two anomalous portions becomes vector I_{abnormal}.

Similarly, vector Iₙₒᵣₘₐₗ is a vector obtained by adding together one or more vectors representing AC current flowing through each of one or more normal portions in main body 79. For example, when two normal portions exist in main body 79, a vector obtained by adding together a vector representing AC current flowing through one of the two normal portions and a vector representing AC current flowing through the other one of the two normal portions becomes vector Iₙₒᵣₘₐₗ.

A vector obtained by adding together vector I_{abnormal} and vector Iₙₒᵣₘₐₗ becomes vector Iₐₗₗ.

The angle that vector I_{abnormal} makes with the horizontal axis is smaller than the angle that vector Iₐₗₗ makes with the horizontal axis, and it can be seen that the phase of the AC current flowing through the anomalous portion lags behind the phase of the AC current flowing through electrode terminal 32 or 33. The angle that vector Iₙₒᵣₘₐₗ makes with the horizontal axis is larger than the angle that vector Iₐₗₗ makes with the horizontal axis, and it can be seen that the phase of the AC current flowing through the normal portion leads the phase of the AC current flowing through electrode terminal 32 or 33.

When no anomaly occurs in main body 79, vector I_{abnormal} is not calculated, and vector Iₙₒᵣₘₐₗ becomes equal to vector Iₐₗₗ. Stated differently, when vector Iₙₒᵣₘₐₗ and vector Iₐₗₗ are equal, it can be seen that no anomaly occurs in main body 79.

Once correction unit 77 calculates vector I_{abnormal} and vector Iₙₒᵣₘₐₗ, correction unit 77 calculates projection vector I'_{abnormal} by projecting vector I_{abnormal} onto a predetermined straight line, and projection vector I'ₙₒᵣₘₐₗ by projecting vector Iₙₒᵣₘₐₗ onto a predetermined straight line.

FIG. 10 describes a case where the predetermined straight line is the vertical axis. Correction unit 77 calculates projection vector I'_{abnormal} and projection vector I'ₙₒᵣₘₐₗ, and outputs a corrected signal indicating the magnitude and direction of projection vector I'_{abnormal} and the magnitude and direction of projection vector I'ₙₒᵣₘₐₗ.

As illustrated in FIG. 11, generation unit 78 generates an image indicating the distribution of AC current in storage battery 31 based on the corrected signal, and display 17 displays the image. In the image illustrated in FIG. 11, darker colors indicate greater magnitudes of AC current as represented by the projection vectors. Looking at the image in FIG. 11, it can be seen that in main body 79, there is a tendency for colors to become darker toward electrode terminals 32 and 33, and there is a tendency for the magnitudes of AC current as represented by the projection vectors to become greater.

Here, when the predetermined straight line is the vertical axis, projection vector I'_{abnormal} is oriented in the same direction as projection vector I'ₙₒᵣₘₐₗ. Therefore, the magnitude of AC current as represented by the projection vector at a certain anomalous portion and the magnitude of AC current as represented by the projection vector at a normal portion in the vicinity of that certain anomalous portion are approximately equal.

Therefore, in the image illustrated in FIG. 11, it is difficult to distinguish between anomalous portions and normal portions, but it is possible to easily distinguish between portions where the magnitude of AC current is large and portions where it is small in storage battery 31.

Next, another example of the predetermined straight line will be given. FIG. 12 describes a case where the predetermined straight line is straight line C that is orthogonal to vector Iₐₗₗ. Correction unit 77 calculates straight line C orthogonal to vector Iₐₗₗ, calculates projection vector I'_{abnormal} by projecting vector I_{abnormal} onto straight line C and projection vector I'ₙₒᵣₘₐₗ by projecting vector Iₙₒᵣₘₐₗ onto straight line C, and outputs a corrected signal indicating the magnitude and direction of projection vector I'_{abnormal} and the magnitude and direction of projection vector I'ₙₒᵣₘₐₗ.

As illustrated in FIG. 13, generation unit 78 generates an image indicating the distribution of AC current in storage battery 31 based on the corrected signal, and display 17 displays the image. In the image of FIG. 13, as in the image of FIG. 11, darker colors indicate greater magnitudes of AC current as represented by the projection vectors. Looking at the image in FIG. 13, it can be seen that colors in a portion of main body 79 have become darker.

Here, when the predetermined straight line is straight line C that is orthogonal to vector Iₐₗₗ, projection vector I'_{abnormal} is oriented in the opposite direction from projection vector I'ₙₒᵣₘₐₗ. Therefore, the difference between the magnitude of AC current as represented by the projection vector at a certain anomalous portion and the magnitude of AC current as represented by the projection vector at a normal portion in the vicinity of that certain anomalous portion can be increased. Note that in FIG. 13, the direction in which projection vector I'_{abnormal} is oriented is taken as the positive side.

Stated differently, in the image of FIG. 13, the portions where colors have become darker indicate anomalous portions, and in the image of FIG. 13, anomalous portions and normal portions can be easily distinguished.

Although a case where the predetermined straight line is a straight line that is orthogonal to vector Iₐₗₗ has been described, the present disclosure is not limited thereto. For example, the predetermined straight line may be a straight line that is orthogonal to vector Iₙₒᵣₘₐₗ, or may be a straight line that is orthogonal to vector I_{abnormal}. For example, the predetermined straight line may be a straight line that is not orthogonal to vector Iₐₗₗ and that causes the direction of projection vector I'ₙₒᵣₘₐₗ and the direction of projection vector I'_{abnormal} to be opposite directions.

This concludes the description of storage battery inspection device 10 according to the embodiment.

Storage battery inspection device 10 according to the embodiment includes charge control circuit 11 that applies an AC current to storage battery 31, magnetic sensor 12 that senses a magnetic field external to storage battery 31, calculation unit 76 that calculates an AC current flowing through storage battery 31 based on a sensing result from magnetic sensor 12, and correction unit 77 that calculates, based on a calculation result from calculation unit 76, one or more vectors I_{abnormal}, Iₙₒᵣₘₐₗ on a complex plane representing the AC current flowing through storage battery 31, calculates one or more projection vectors I'_{abnormal}, I'ₙₒᵣₘₐₗ by projecting the calculated one or more vectors I_{abnormal}, Iₙₒᵣₘₐₗ onto a predetermined straight line on the complex plane, and outputs a corrected signal indicating magnitudes of the calculated one or more projection vectors I'_{abnormal}, I'ₙₒᵣₘₐₗ.

This enables calculation of one or more vectors I_{abnormal}, Iₙₒᵣₘₐₗ on a complex plane representing AC current flowing through storage battery 31, calculation of one or more projection vectors I'_{abnormal}, I'ₙₒᵣₘₐₗ by projecting the one or more vectors I_{abnormal}, Iₙₒᵣₘₐₗ onto a predetermined straight line on the complex plane, and output of a corrected signal indicating the magnitudes of the one or more projection vectors I'_{abnormal}, I'ₙₒᵣₘₐₗ. Therefore, when an anomaly occurs in storage battery 31, vector I_{abnormal} representing AC current flowing through the anomalous portion and vector Iₙₒᵣₘₐₗ representing AC current flowing through the normal portion in the vicinity of that anomalous portion can be calculated. While it would be difficult to distinguish between anomalous portions and normal portions by merely outputting the magnitudes of these vectors, as described above, by calculating projection vectors I'_{abnormal}, I'ₙₒᵣₘₐₗ and outputting their magnitudes, it becomes easy to make the output value indicating the magnitude of AC current at an anomalous portion different from the output value indicating the magnitude of AC current at a normal portion. This makes it easy to distinguish between anomalous portions and normal portions, thus making it possible to more appropriately inspect storage battery 31.

In storage battery inspection device 10 according to the embodiment, storage battery 31 includes main body 79 and electrode terminals 32 and 33 connected to main body 79, and the predetermined straight line is orthogonal to vector Iₐₗₗ on the complex plane representing AC current flowing through the entirety of main body 79.

This enables output of the magnitudes of one or more projection vectors I'_{abnormal}, I'ₙₒᵣₘₐₗ projected onto straight line C that is orthogonal to vector Iₐₗₗ on the complex plane representing AC current flowing through the entirety of main body 79 of storage battery 31. For example, the phase of AC current flowing through an anomalous portion in main body 79 lags behind the phase of AC current flowing through the entirety of main body 79, and accordingly, the phase of AC current flowing through a normal portion in main body 79 leads the phase of AC current flowing through the entirety of main body 79. Stated differently, with respect to vector Iₐₗₗ representing AC current flowing through the entirety of main body 79, the direction of vector I_{abnormal} representing AC current flowing through the anomalous portion in main body 79 and the direction of vector Iₙₒᵣₘₐₗ representing AC current flowing through the normal portion in main body 79 are opposite directions. Therefore, by calculating projection vectors I'_{abnormal}, I'ₙₒᵣₘₐₗ as described above, it is possible to increase the difference between the output value indicating the magnitude of AC current flowing through the anomalous portion in main body 79 and the output value indicating the magnitude of AC current flowing through the normal portion in main body 79, making it even easier to distinguish between anomalous portions and normal portions. This makes it possible to more appropriately inspect storage battery 31.

Storage battery inspection device 10 according to the embodiment further includes: generation unit 78 configured to generate an image indicating a distribution of the AC current flowing through storage battery 31 based on the corrected signal output by correction unit 77; and display 17 configured to display the image generated by generation unit 78.

This enables display of an image indicating the distribution of AC current flowing through storage battery 31, making it easy to understand at which position in storage battery 31 an anomaly has occurred, and making it possible to more appropriately inspect storage battery 31.

Hereinbefore, aspects of the storage battery inspection device have been described based on an embodiment, but the aspects of the storage battery inspection device are not limited to the embodiment. Variations conceivable by a person skilled in the art may be made to the embodiment, and a plurality of elements in the embodiment may be arbitrarily combined. For example, in the embodiment, processing performed by a particular element may be performed by a different element instead of the particular element. Moreover, the order of the plurality of processes may be changed, or the plurality of processes may be executed in parallel.

A storage battery inspection method including steps performed by each element of the storage battery inspection device may be executed by any device or system. For example, part or all of the storage battery inspection method may be executed by a computer including a processor, memory, input/output circuits, and the like. Here, the storage battery inspection method may be executed by a computer executing a program for causing the computer to execute the storage battery inspection method.

The above program may be recorded on a non-transitory computer-readable recording medium.

Each element of the storage battery inspection device may be configured of dedicated hardware, may be configured of general-purpose hardware that executes the above program and the like, or may be configured of a combination thereof. The general-purpose hardware may be configured of memory on which a program is recorded, a general-purpose processor that reads and executes the program from the memory, and the like. Here, the memory may be semiconductor memory or a hard disk or the like, and the general-purpose processor may be a CPU or the like.

The dedicated hardware may be configured of memory, a dedicated processor, and the like. For example, the dedicated processor may execute the above storage battery inspection method by referencing memory for recording measurement data.

Each element of the storage battery inspection device may be an electric circuit. These electric circuits may constitute a single electric circuit as a whole or may be separate electric circuits. These electric circuits may correspond to dedicated hardware or may correspond to general-purpose hardware that executes the above program and the like.

### [Industrial Applicability]

One aspect of the present disclosure is useful for a storage battery inspection device for inspecting storage batteries and is applicable to storage battery manufacturing systems and the like.

### [Reference Signs List]

- 10: storage battery inspection device
- 11: charge control circuit
- 12: magnetic sensor
- 13: cancel coil
- 14: feedback circuit
- 15: detection circuit
- 16: imaging circuit
- 17: display
- 18: preamplifier
- 19: high-pass filter (HPF)
- 21: measurement unit
- 22: turntable
- 23: power supply unit
- 24: information processing unit
- 25: soft layer
- 26: tunnel layer
- 27: PIN layer (magnetization pinned layer)
- 31: storage battery
- 32, 33: electrode terminal
- 34, 35: electrode plate
- 36: dendrite
- 37: electrolyte
- 38: metal package
- 41: scanning target surface
- 42: reconstruction target surface
- 51: signal processing circuit
- 52: current amplification circuit
- 71: direct injection box (DI)
- 72: analog-to-digital converter (ADC)
- 73: mixer
- 74: low-pass filter
- 75: storage circuit
- 76: calculation unit
- 77: correction unit
- 78: generation unit
- 79: main body

## Claims

1. A storage battery inspection device comprising:
an application unit configured to apply an alternating current (AC) current to a storage battery;
a sensing unit configured to sense a magnetic field external to the storage battery;
a calculation unit configured to calculate an AC current flowing through the storage battery based on a sensing result from the sensing unit; and
a correction unit configured to calculate, based on a calculation result from the calculation unit, one or more vectors on a complex plane representing the AC current flowing through the storage battery, calculate one or more projection vectors by projecting the one or more vectors calculated onto a predetermined straight line on the complex plane, and output a corrected signal indicating magnitudes of the one or more projection vectors calculated.

2. The storage battery inspection device according to claim 1, wherein
the storage battery includes a main body and an electrode terminal connected to the main body, and
the predetermined straight line is orthogonal to a vector on the complex plane representing AC current flowing through an entirety of the main body.

3. The storage battery inspection device according to claim 1 or 2, further comprising:
a generation unit configured to generate an image indicating a distribution of the AC current flowing through the storage battery based on the corrected signal output by the correction unit; and
a display unit configured to display the image generated by the generation unit.

4. A storage battery inspection method comprising:
applying, by an application unit, an alternating current (AC) current to a storage battery;
sensing, by a sensing unit, a magnetic field external to the storage battery;
calculating, by a calculation unit, an AC current flowing through the storage battery based on a sensing result from the sensing unit; and
calculating, by a correction unit, based on a calculation result from the calculation unit, one or more vectors on a complex plane representing the AC current flowing through the storage battery, calculating one or more projection vectors by projecting the one or more vectors calculated onto a predetermined straight line on the complex plane, and outputting a corrected signal indicating magnitudes of the one or more projection vectors calculated.
